# EUROPEAN PATENT APPLICATION

(11) **EP 4 467 902 A2**
(43) Date of publication of application: **27.11.2024**
(21) Application number: 24176772.2
(22) Date of filing: 17.05.2024
(51) Int. Cl.: F25B 41/00, F25B 49/02

(54) **SYSTEMS AND METHODS FOR CONTROLLING PUMPED TWO-PHASE REFRIGERANT TEMPERATURE**

(30) Priority: 23.05.2023 US 202363503594 P
(71) Applicant: Vertiv Corporation, Westerville, OH 43082 (US)
(72) Inventor: TIPTON, Russell, Westerville, 43081 (US); SHORES, Craig, Columbus, 43220 (US)
(74) Representative: Bryn-Jacobsen, Caelia

(57) **Abstract**

A method can include pumping the refrigerant through an evaporator in thermal communication with a heat load, thereby heating the refrigerant and causing at least some of the refrigerant to change from a liquid phase to a vapor phase, cooling the refrigerant in a condenser fluidically downstream from the evaporator, thereby causing at least some of the refrigerant to change from the vapor phase to the liquid phase, extracting a portion of the refrigerant in the vapor phase fluidically between the evaporator and the condenser, and injecting the extracted portion of the refrigerant, in the vapor phase, fluidically between the pump and the evaporator, thereby increasing the temperature of the refrigerant entering the evaporator to minimize single-phase cooling in the evaporator.

## Description

### CROSS-REFERENCE TO RELATED APPLICATIONS

This application claims the benefit of U.S. Provisional Patent Application No. 63/503,954 filed May 23, 2023.

### BACKGROUND OF THE INVENTION

Field of the Invention. The present disclosure relates generally to cooling systems, such as those used in data centers, and more specifically relates to pumped two-phase refrigerant cooling systems.

Description of the Related Art. As computing systems continue to grow to meet increasing demands, such as artificial intelligence (Al) and machine learning (ML), data centers look to improve their sustainability. Phase change heat transfer (often referred to as Pumped Two-Phase (P2P)), such as evaporation in a directly mounted (to the chip) two-phase cold plate (2PCP), appears to offer the most effective thermal transfer.

However, current working fluids (refrigerants) and/or cooling systems do not have ideal properties. For example, an ideal working fluid would have zero liquid specific heat resulting in zero liquid subcooling entering the 2PCP. However, current pumps can be damaged by ingesting a working fluid in vapor phase. For example, a working fluid near its boiling point can contain some working fluid in vapor phase and/or can cause cavitation, or bubble formation at the pump suction point, which damages the pump, such as upon bubble collapse. Thus, current working fluids must be subcooled, well below their boiling point, to ensure the pump does not ingest vapor and/or to avoid such bubble formation.

When subcooled working fluid enters a 2PCP, the first heat transfer is to remove the subcooling. This single-phase heat transfer occurs with a heat transfer coefficient (HTC) that is much smaller that the HTC of phase change (evaporative) heat transfer. Where there is a uniform distribution heat and/or flow, single-phase heat transfer can diminish the 2PCP performance and can create hot spots which can cause CPU thermal throttling, loss of performance, and/or other failures.

### SUMMARY OF THE INVENTION

Applicants have created new and useful devices, systems and methods for controlling pumped two-phase refrigerant temperature. In at least one example, a system for controlling pumped two-phase refrigerant temperature can include a pump configured to pump a refrigerant through an evaporator in thermal communication with a heat load, a condenser in fluid communication with the pump and the evaporator, a controller configured to control a temperature of the refrigerant entering the evaporator to minimize single-phase cooling in the evaporator, or any combination thereof. In at least one example, refrigerant within the evaporator can be heated by the heat load, thereby causing at least some of the refrigerant to change from a liquid phase to a vapor phase. In at least one example, the condenser can be configured to cool the refrigerant fluidically downstream from the evaporator, thereby causing at least some of the refrigerant to change from the vapor phase to the liquid phase before returning to the pump. In at least one example, a system for controlling pumped two-phase refrigerant temperature can further include a compressor configured to inject the refrigerant in the vapor phase fluidically between the pump and the evaporator.

In at least one example, a system for controlling pumped two-phase refrigerant temperature can further include a separator configured to separate refrigerant extracted fluidically between the evaporator and the condenser into a portion of the refrigerant in the vapor phase and a portion of the refrigerant in the liquid phase. In at least one example, the separator can be configured to inject the portion of the refrigerant in the liquid phase fluidically between the pump and the condenser.

In at least one example, the controller can be configured to control a speed of the compressor according to the temperature of the refrigerant entering the evaporator. In at least one example, the controller can be configured to monitor the temperature and pressure of the refrigerant entering the evaporator. In at least one example, the controller can be configured to control a valve downstream of the compressor according to the temperature of the refrigerant entering the evaporator.

In at least one example, a system for controlling pumped two-phase refrigerant temperature can include a plurality of two-phase cold plates, a pump configured to pump a refrigerant through the plurality of two-phase cold plates, a condenser in fluid communication with the pump and the plurality of two-phase cold plates, a separator in fluid communication with the condenser and the plurality of two-phase cold plates, a compressor configured to inject the portion of the refrigerant in the vapor phase fluidically between the pump and the plurality of two-phase cold plates, a controller configured to control the speed of the compressor to minimize single-phase cooling in the plurality of two-phase cold plates, or any combination thereof. In at least one example, any or all of the two-phase cold plates can be in thermal communication with a heat load. In at least one example, any or all of the two-phase cold plates can be plumbed in parallel fluid communication with one another. In at least one example, any or all of the two-phase cold plates can be plumbed in series fluid communication with one another. In at least one example, any or all of the plurality of two-phase cold plates can be heated, by the heat load(s), thereby causing at least some of the refrigerant to change from a liquid phase to a vapor phase. In at least one example, the controller can be configured to monitor the temperature and/or pressure of refrigerant entering the plurality of two-phase cold plates.

In at least one example, the condenser can be configured to cool the refrigerant fluidically downstream from the plurality of two-phase cold plates, thereby causing the refrigerant to change from the vapor phase to the liquid phase before returning to the pump. In at least one example, the separator can be configured to extract some of the refrigerant fluidically between the condenser and the plurality of two-phase cold plates. In at least one example, the separator can be configured to separate the extracted refrigerant into a portion of the refrigerant in the vapor phase and a portion of the refrigerant in the liquid phase. In at least one example, the separator can be configured to inject the portion of the refrigerant in the liquid phase fluidically between the pump and the condenser.

In at least one example, a method of controlling a temperature of a refrigerant can include pumping, such as with a pump, the refrigerant through an evaporator, thereby heating the refrigerant and causing at least some of the refrigerant to change from a liquid phase to a vapor phase, cooling the refrigerant in a condenser fluidically downstream from the evaporator, thereby causing at least some of the refrigerant to change from the vapor phase to the liquid phase before returning to the pump, extracting a portion of the refrigerant in the vapor phase fluidically between the evaporator and the condenser, injecting the extracted portion of the refrigerant, in the vapor phase, fluidically between the pump and the evaporator, thereby increasing the temperature of the refrigerant entering the evaporator, or any combination thereof. In at least one example, the evaporator can be in thermal communication with a heat load.

In at least one example, injecting the extracted portion of the refrigerant in the vapor phase can include compressing, such as with a compressor, the extracted portion of the refrigerant in the vapor phase. In at least one example, a method of controlling a temperature of a refrigerant can further include separating the extracted portion of the refrigerant extracted between the evaporator and the condenser into the portion of the refrigerant in the vapor phase and a portion of the refrigerant in the liquid phase.

In at least one example, a method of controlling a temperature of a refrigerant can further include injecting the portion of the refrigerant in the liquid phase fluidically between the pump and the condenser. In at least one example, a method of controlling a temperature of a refrigerant can further include controlling a speed of the compressor according to the temperature of the refrigerant entering the evaporator. In at least one example, a method of controlling a temperature of a refrigerant can further include monitoring the temperature and pressure of the refrigerant entering the evaporator. In at least one example, a method of controlling a temperature of a refrigerant can further include controlling a valve fluidically downstream of the compressor according to the temperature of the refrigerant entering the evaporator.

In at least one example, a method of controlling a temperature of a refrigerant can include ensuring that the extracted portion of the refrigerant extracted between the evaporator and the condenser is in the vapor phase. In at least one example, a method of controlling a temperature of a refrigerant can include ensuring that the extracted portion of the refrigerant extracted between the evaporator and the condenser is not in the liquid phase. In at least one example, a method of controlling a temperature of a refrigerant can include minimizing single-phase cooling in the evaporator by controlling the temperature of the refrigerant entering the evaporator.

### BRIEF DESCRIPTION OF DRAWINGS

FIG. 1 is a process flow diagram of one of many examples of a system for controlling a temperature of a refrigerant according to the disclosure.
FIG. 2 is a process flow diagram of another of many examples of a system for controlling a temperature of a refrigerant according to the disclosure.
FIG. 3 is a process flow diagram of still another of many examples of a system for controlling a temperature of a refrigerant according to the disclosure.
FIG. 4 is a non-limiting exemplary pressure/enthalpy plot for one of many examples of a system and/or method for controlling a temperature of a refrigerant according to the disclosure.
FIG. 5 is another non-limiting exemplary pressure/enthalpy plot for one of many examples of a system and/or method for controlling a temperature of a refrigerant according to the disclosure.
FIG. 6 is a model of one of many examples of a system for controlling a temperature of a refrigerant according to the disclosure.
FIG. 7 is a close-up view of the upper left quadrant of the model of FIG. 6.
FIG. 8 is a close-up view of the upper right quadrant of the model of FIG. 6.
FIG. 9 is a close-up view of the lower left quadrant of the model of FIG. 6.
FIG. 10 is a close-up view of the lower right quadrant of the model of FIG. 6.
FIG. 11 is another non-limiting exemplary pressure/enthalpy plot for one of many examples of a system and/or method for controlling a temperature of a refrigerant according to the disclosure.

### DETAILED DESCRIPTION OF THE INVENTION

The figures described above and the written description of specific structures and functions below are not presented to limit the scope of what Applicants have invented or the scope of the appended claims. Rather, the figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example incorporating aspects of the present inventions will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various examples of the present disclosure. In this regard, each block in a flowchart may represent a module, segment, or portion of code, which can include one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of a flowchart illustration can be implemented by special purpose hardware-based systems that perform the specified functions or acts, or combinations of special purpose hardware and computer instructions.

Applicants have created new and useful devices, systems and methods for controlling pumped two-phase refrigerant temperature. In at least one example, a system can include one or more pumps for pumping refrigerant through one or more evaporators in thermal communication with one or more heat loads, one or more condensers, and one or more controllers for controlling a temperature of the refrigerant(s) at one or more points in the system, such as at an evaporator inlet, for minimizing single-phase cooling in the evaporator. In at least one example, refrigerant can be heated, thereby causing at least some of the refrigerant to change from a liquid phase to a vapor phase. In at least one example, a condenser can be configured to cool the refrigerant fluidically downstream from an evaporator, thereby causing at least some of the refrigerant to change from the vapor phase to the liquid phase before returning to a pump. In at least one example, a system for controlling pumped two-phase refrigerant temperature can include a compressor configured to inject refrigerant in the vapor phase fluidically between a pump and an evaporator. One or more examples of the disclosure are described in more detail herein with reference to the accompanying figures.

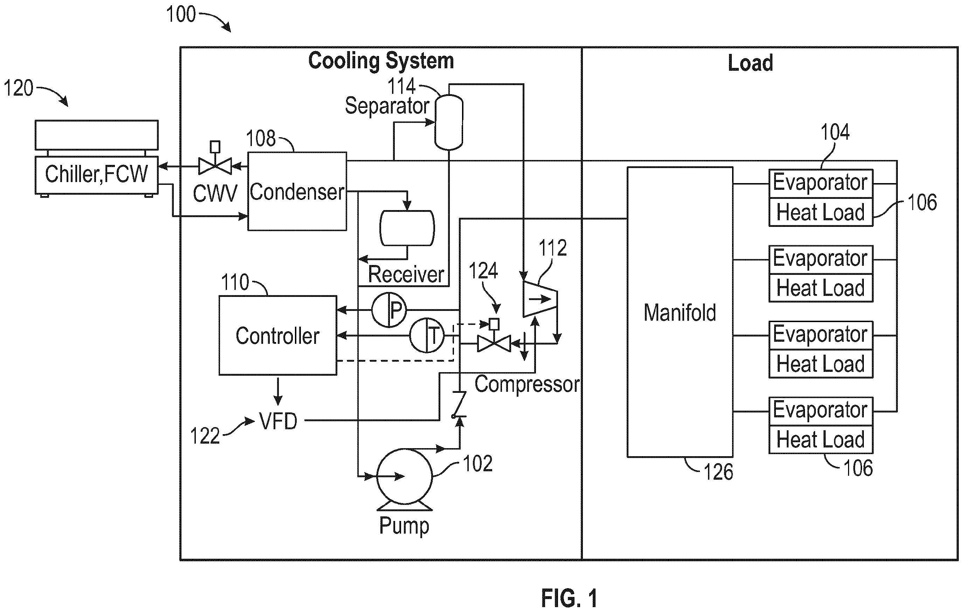

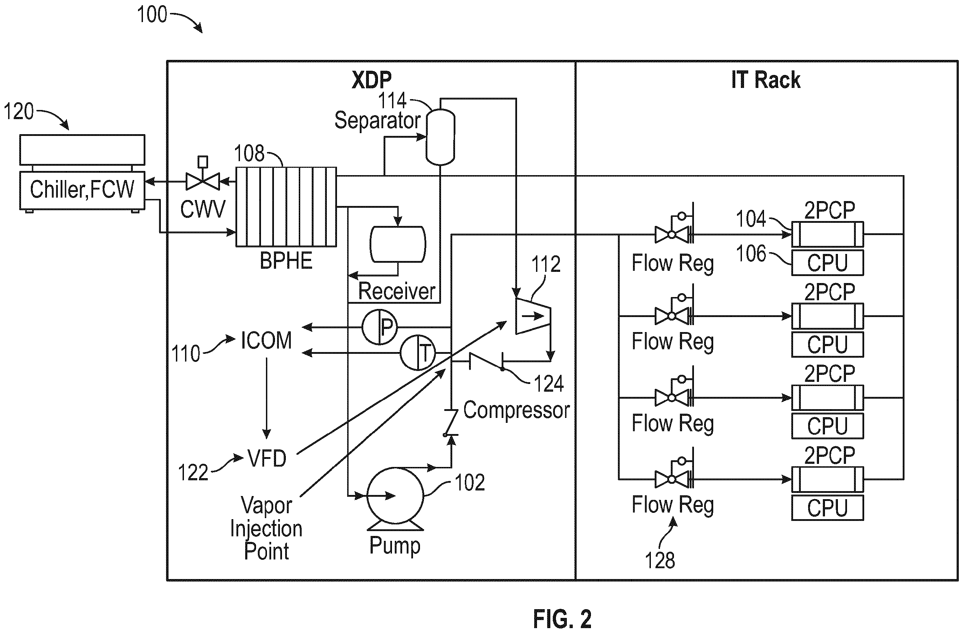

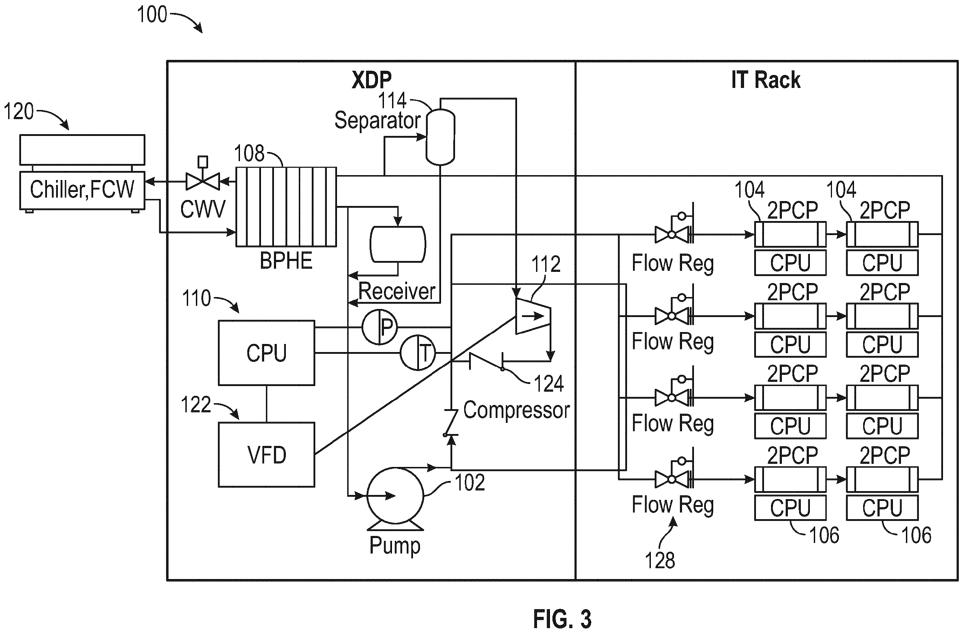

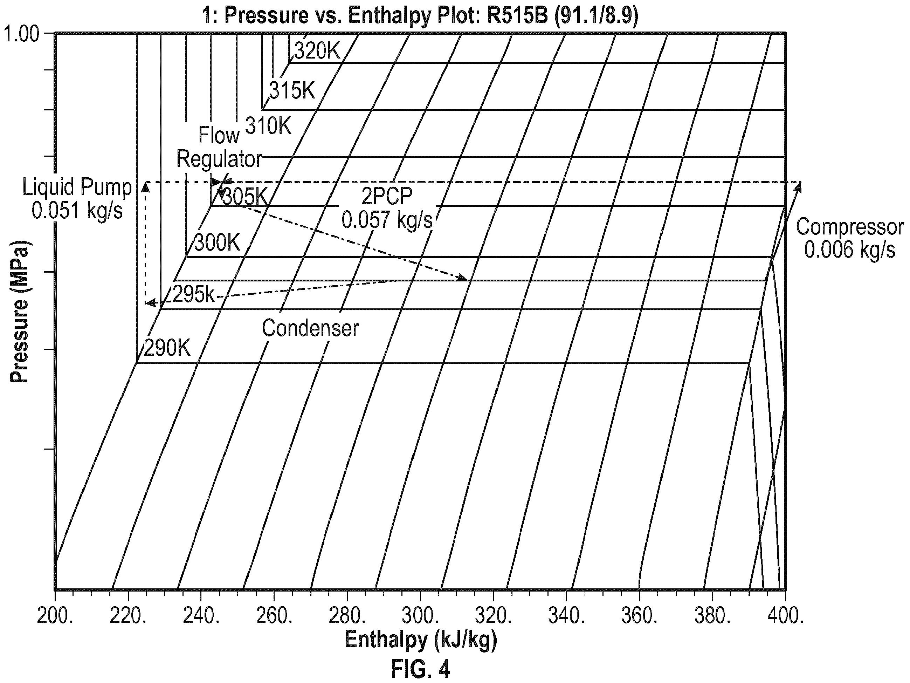

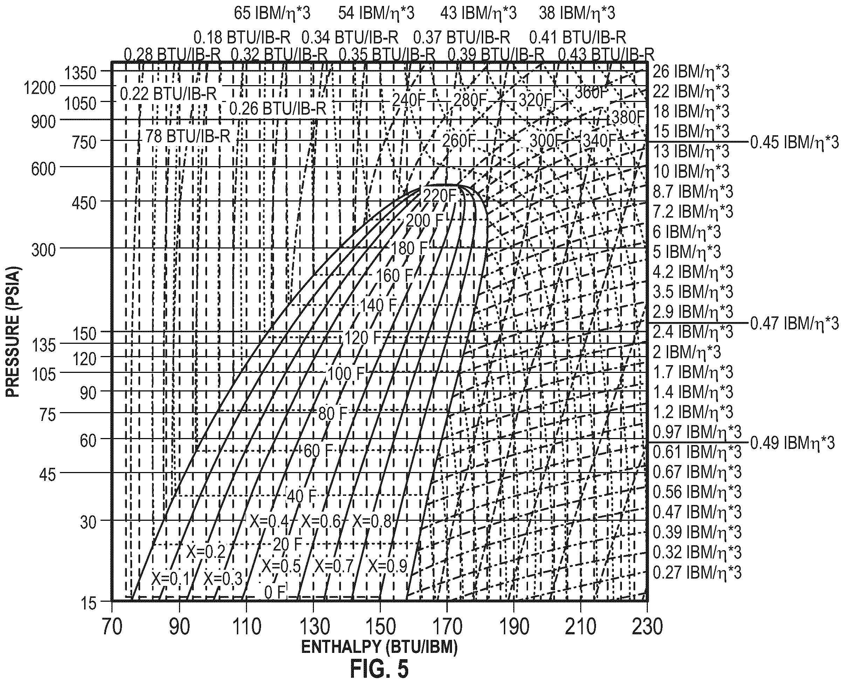

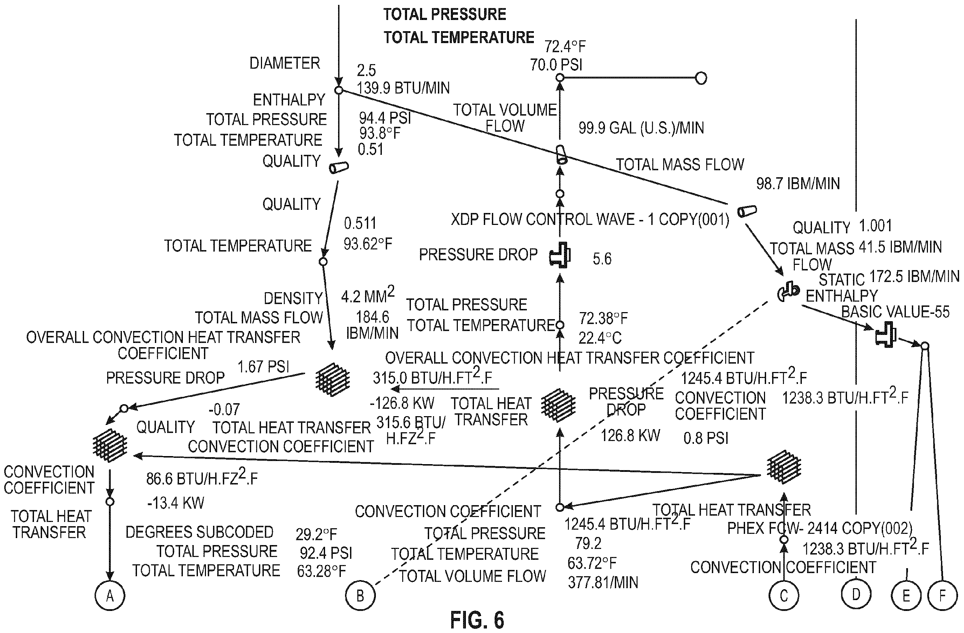

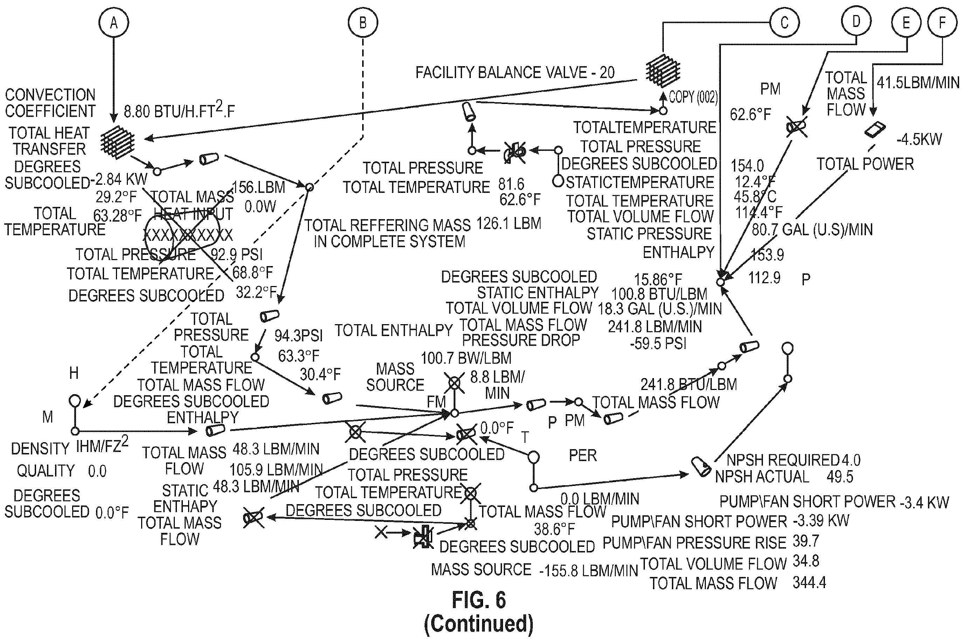

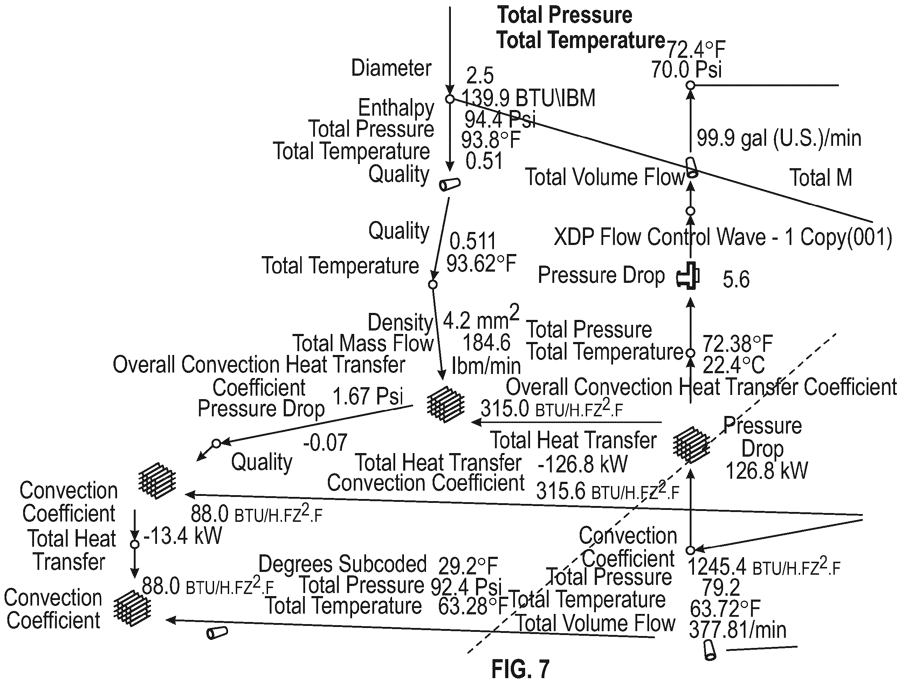

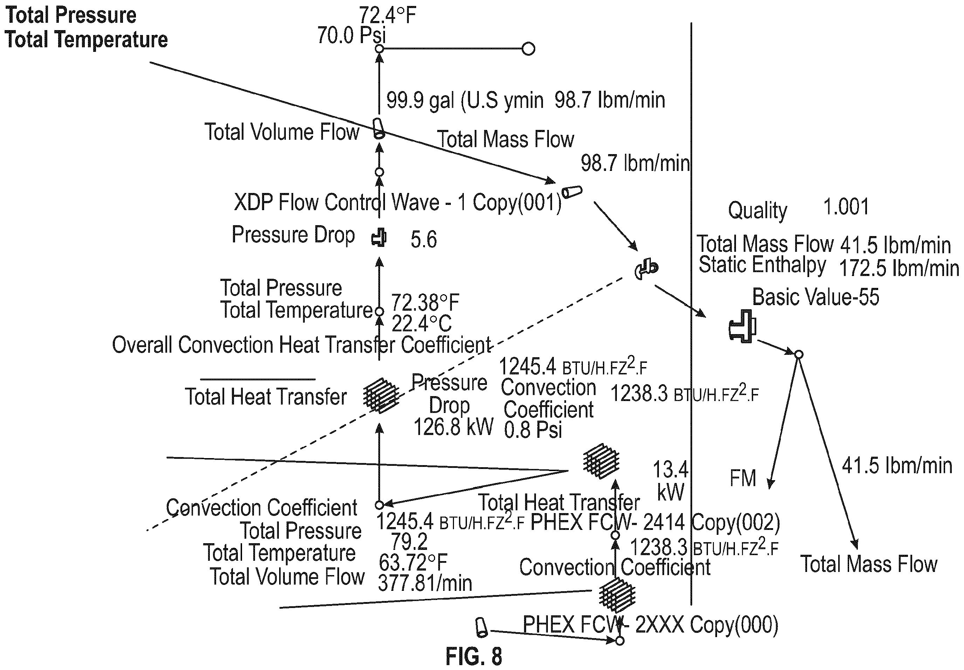

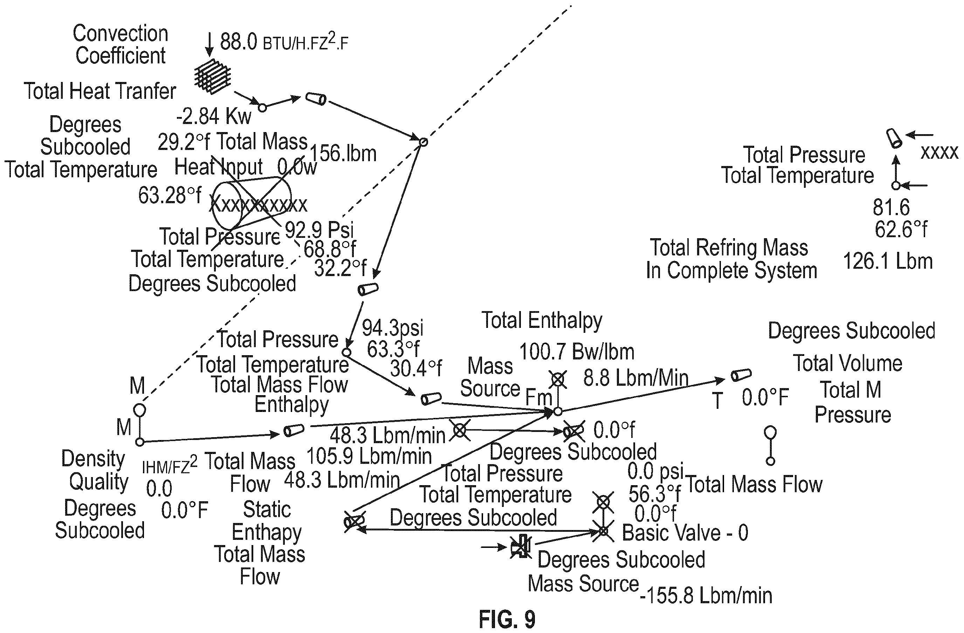

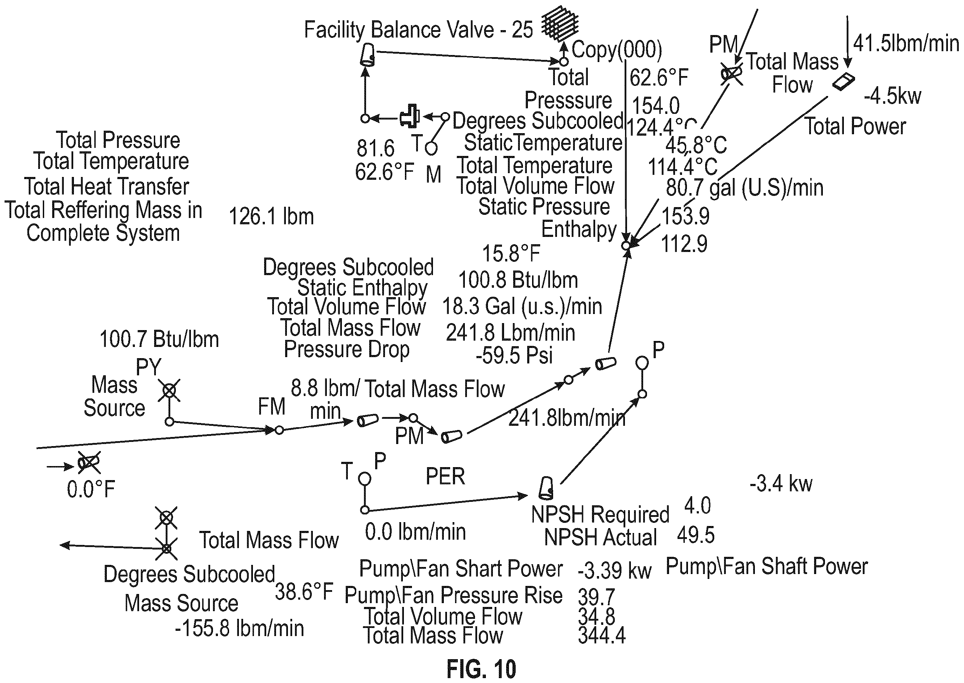

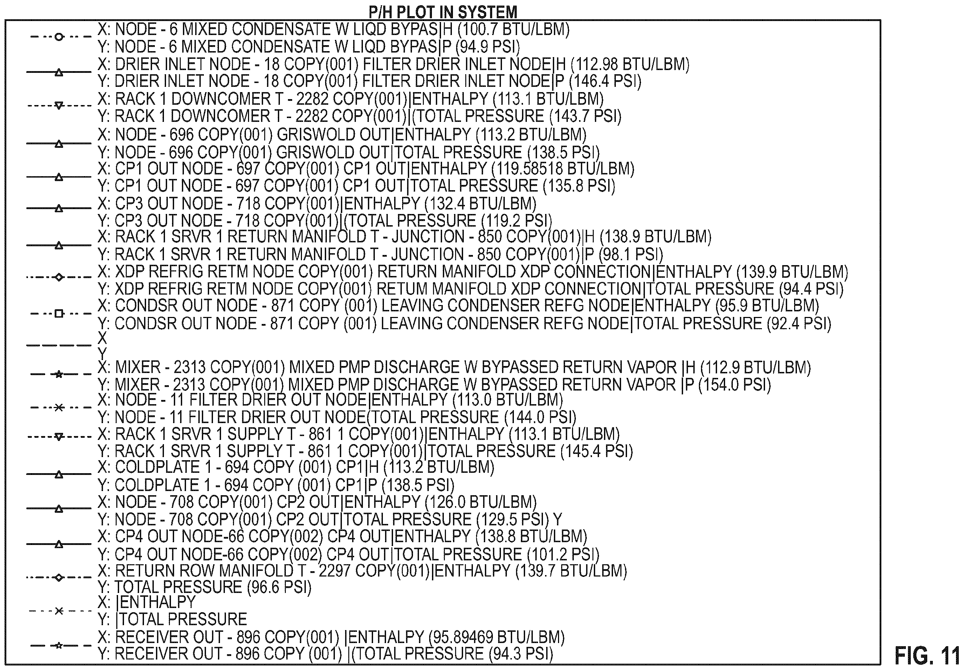

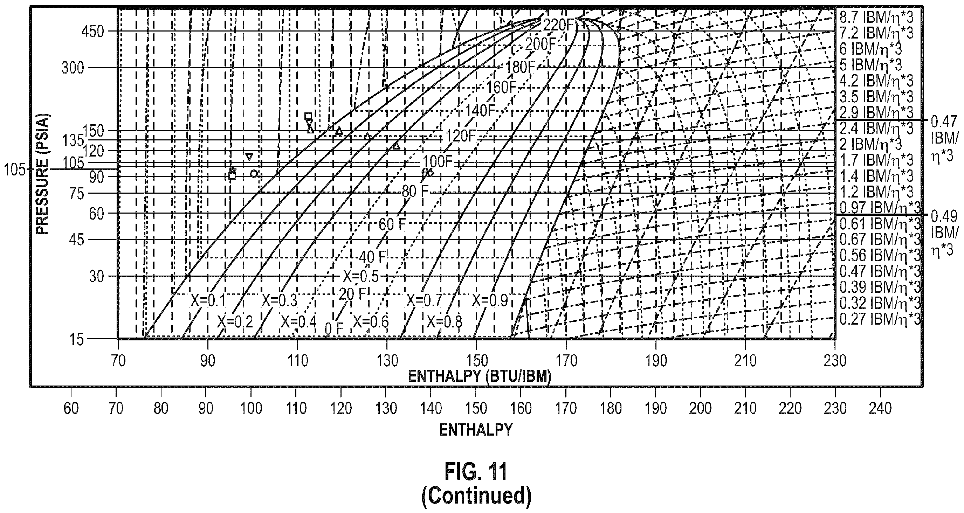

FIG. 1 is a process flow diagram of one of many examples of a system for controlling a temperature of a refrigerant according to the disclosure. FIG. 2 is a process flow diagram of another of many examples of a system for controlling a temperature of a refrigerant according to the disclosure. FIG. 3 is a process flow diagram of still another of many examples of a system for controlling a temperature of a refrigerant according to the disclosure. FIG. 4 is a non-limiting exemplary pressure/enthalpy plot for one of many examples of a system and/or method for controlling a temperature of a refrigerant according to the disclosure. FIG. 5 is another non-limiting exemplary pressure/enthalpy plot for one of many examples of a system and/or method for controlling a temperature of a refrigerant according to the disclosure. FIG. 6 is a model of one of many examples of a system for controlling a temperature of a refrigerant according to the disclosure. FIG. 7 is a close-up view of the upper left quadrant of the model of FIG. 6. FIG. 8 is a close-up view of the upper right quadrant of the model of FIG. 6. FIG. 9 is a close-up view of the lower left quadrant of the model of FIG. 6. FIG. 10 is a close-up view of the lower right quadrant of the model of FIG. 6. FIG. 11 is another non-limiting exemplary pressure/enthalpy plot for one of many examples of a system and/or method for controlling a temperature of a refrigerant according to the disclosure. FIGS. 1-11 are described in conjunction with one another.

In at least one example, a system 100 according to the disclosure, such as a system for controlling a heat transfer system, a system for cooling, or a system for controlling pumped two-phase refrigerant and/or refrigerant temperature, can include a pump 102 configured to pump a refrigerant through an evaporator 104 in thermal communication with a heat load 106, a condenser 108 in fluid communication with the pump 102 and the evaporator 104, a controller 110 configured to control a temperature of the refrigerant entering or returning to the evaporator 104 to minimize single-phase cooling in the evaporator 104, or any combination thereof. In at least one example, there can be multiple heat loads 106. In at least one example, the heat load(s) 106 can be one or more Central Processing Unit(s) (CPUs), Graphics Processing Unit(s) (GPUs), other equipment one might find in a data center, or any combination thereof.

In at least one example, there can be multiple evaporators 104, such as, for example, one evaporator 104 for each heat load 106. In at least one example, heat from the heat load(s) 106 can heat refrigerant within the evaporator(s) 104, thereby causing at least some of the refrigerant to change from a liquid phase to a vapor phase. In at least one example, the evaporator(s) 104 can be or include two-phase cold plates, which can be in thermal communication with one or more CPUs and/or GPUs. In at least one example, any or all of the evaporator(s) 104 can be plumbed in parallel fluid communication with one or more other evaporators 104, such as through one or more manifolds 126 and/or one or more flow regulators 128. In at least one example, any or all of the evaporator(s) 104 can be plumbed in series fluid communication with one or more other evaporators 104, such as through one or more manifolds 126 and/or one or more flow regulators 128. In at least one example, any or all of the evaporator(s) 104 can be plumbed in parallel and series fluid communication with one or more other evaporators 104, such as through one or more manifolds 126 and/or one or more flow regulators 128.

In at least one example, the condenser 108 can be configured to cool the refrigerant fluidically downstream from the evaporator 104, thereby causing at least some of the refrigerant to change from the vapor phase to the liquid phase before returning to the pump 102. In at least one example, the condenser 108 can be a liquid-to-liquid heat exchanger and/or may be cooled by a chilled water cooling system 120. In at least one example, the condenser 108 can be a liquid-to-air heat exchanger and/or may be air cooled. In at least one example, the condenser 108 can be a brazed plate heat exchanger. In at least one example, the condenser 108 can be a cold plate cooled by an external cooling system 120.

In at least one example, a system 100 for controlling pumped two-phase refrigerant temperature can further include a compressor 112 configured to inject the refrigerant in the vapor phase fluidically between the pump 102 and the evaporator 104. In at least one example, the controller 110 can be configured to control a speed of the compressor 112, such as through the use of a variable frequency drive (VFD) 122, according to the temperature of the refrigerant entering or returning to the evaporator 104. In at least one example, the controller 110 can be configured to monitor the temperature and pressure of the refrigerant entering or returning to the evaporator 104. In at least one example, the controller 110 can be configured to control a valve 124 downstream of the compressor 112 according to the temperature of the refrigerant entering or returning to the evaporator 104. In at least one example, valve 124 can limit or prevent liquid backflow through compressor 112. For instance, during system operation, in at least one example, refrigerant pressure downstream of pump 102 can be, and typically will be, higher than refrigerant pressure at separator 114, such that refrigerant downstream of pump 102 may be inclined to backflow into compressor 112 in the absence of valve 124, which could, for example, reduce system efficiency and/or cause damage to compressor 112. In at least one example, as suggested above, valve 124 can be or include one or more electrically or electronically controlled valves (see, e.g., FIG. 1). As another example, in at least one example, valve 124 can be or include one or more check valves (see, e.g., FIGS. 2-3), whether separately or in combination with one another and/or with one or more electrically or electronically controlled valves. In at least one example, one or more controller(s) 110 can be or include a Liebert° iCOM^{™} cooling unit controller, or another controller capable of operation in accordance with an example of the present disclosure.

In at least one example, a system 100 for controlling pumped two-phase refrigerant temperature can further include a separator 114 configured to separate refrigerant extracted fluidically between the evaporator 104 and the condenser 108 into a portion of the refrigerant in the vapor phase and a portion of the refrigerant in the liquid phase. In at least one example, the separator 114 can be configured to inject the portion of the refrigerant in the liquid phase fluidically between the pump 102 and the condenser 108. In at least one example, the separator 114 can be configured to extract only refrigerant in the vapor phase, such as by taking refrigerant from a top-most (or otherwise configured) vapor port of a vessel and/or plumbing, thereby combining extraction and separation.

In at least one example one or more evaporators 104 can be or include one or more cold plates. In at least one example, a system 100 for controlling pumped two-phase refrigerant temperature can include a plurality of two-phase cold plates 104, a pump 102 configured to pump refrigerant through the plurality of two-phase cold plates 104, a condenser 108 in fluid communication with the pump 102 and the plurality of two-phase cold plates 104, a separator 114 in fluid communication with the condenser 108 and the plurality of two-phase cold plates 104, a compressor 112 configured to inject the portion of the refrigerant in the vapor phase fluidically between the pump 102 and the plurality of two-phase cold plates 104, a controller 110 configured to control the speed of the compressor 112 to minimize single-phase cooling in the two-phase cold plates 104, or any combination thereof. In at least one example, any or all of the two-phase cold plates 104 can be in thermal communication with one or more heat loads 106, such as a CPU, GPU, other computing equipment, or any combination thereof. In at least one example, any or all of the two-phase cold plates 104 can be plumbed in parallel and/or series fluid communication with one another, such as through one or more manifolds 126 and/or one or more flow regulators 128. In at least one example, refrigerant within any or all of the plurality of two-phase cold plates 104 can by heated, by way of heat transfer with one or more heat load(s) 106, thereby causing at least some of the refrigerant to change from a liquid phase to a vapor phase. In at least one example, the controller 110 can be configured to monitor the temperature and pressure of the refrigerant entering or returning to the evaporator.

In at least one example, the condenser 108 can be configured to cool the refrigerant fluidically downstream from the plurality of two-phase cold plates 104, thereby causing the refrigerant to change from the vapor phase to the liquid phase before returning to the pump 102. In at least one example, the separator 114 can be configured to extract some of the refrigerant fluidically between the condenser 108 and the plurality of two-phase cold plates 104. In at least one example, the separator 114 can be configured to separate the extracted refrigerant into a portion of the refrigerant in the vapor phase and a portion of the refrigerant in the liquid phase. In at least one example, the separator 114 can be configured to inject the portion of the refrigerant in the liquid phase fluidically between the pump 102 and the condenser 108. In at least one example, the separator 114 can be configured to extract only refrigerant in the vapor phase.

In at least one example, a method according to the disclosure, such as a method for controlling a heat transfer system, a method for cooling, or a method for controlling pumped two-phase refrigerant and/or refrigerant temperature, can include pumping, such as with a pump 102, the refrigerant through an evaporator 104, thereby heating the refrigerant and causing at least some of the refrigerant to change from a liquid phase to a vapor phase, cooling the refrigerant in a condenser 108 fluidically downstream from the evaporator 104, thereby causing at least some of the refrigerant to change from the vapor phase to the liquid phase before returning to the pump 102, extracting a portion of the refrigerant in the vapor phase fluidically between the evaporator 104 and the condenser 108, injecting the extracted portion of the refrigerant, in the vapor phase, fluidically between the pump 102 and the evaporator 104, thereby increasing the temperature of the refrigerant entering, or returning to, the evaporator 104, or any combination thereof.

In at least one example, the evaporator 104 can be in thermal communication with a heat load 106, such as a CPUs, GPUs, other equipment one might find in a data center, or any combination thereof. In at least one example, there can be multiple heat load(s) 106 and/or multiple evaporators 104, such as one for each heat load 106. In at least one example, the evaporator(s) 104 can include two-phase cold plates, which can be in thermal communication with one or more CPUs and/or GPUs.

In at least one example, injecting the extracted portion of the refrigerant in the vapor phase can include compressing, such as with a compressor 112, the extracted portion of the refrigerant in the vapor phase. In at least one example, a method of controlling a temperature of a refrigerant can further include separating the extracted portion of the refrigerant extracted between the evaporator 104 and the condenser 106 into the portion of the refrigerant in the vapor phase and a portion of the refrigerant in the liquid phase.

In at least one example, a method of controlling a temperature of a refrigerant can further include injecting the portion of the refrigerant in the liquid phase fluidically between the pump 102 and the condenser 108. In at least one example, a method of controlling a temperature of a refrigerant can further include controlling a speed of the compressor 112, such as with a VFD 122, according to the temperature of the refrigerant entering, or returning to, the evaporator 104. In at least one example, a method of controlling a temperature of a refrigerant can further include monitoring the temperature and pressure of the refrigerant entering or returning to the evaporator 104. In at least one example, a method of controlling a temperature of a refrigerant can further include controlling a valve 124 fluidically downstream of the compressor 112 according to the temperature of the refrigerant entering or returning to the evaporator 104. In at least one example, valve 124 can limit or prevent liquid backflow through compressor 112, such as for avoiding damage to compressor 112.

In at least one example, a method of controlling a temperature of a refrigerant can include ensuring that an extracted portion of refrigerant extracted between an evaporator 104 and a condenser 108 is in the vapor phase. In at least one example, a method of controlling a temperature of a refrigerant can include ensuring that the extracted portion of the refrigerant extracted between the evaporator 104 and the condenser 108 is not in the liquid phase. In at least one example, a method of controlling a temperature of a refrigerant can include minimizing single-phase cooling in the evaporator 104 by controlling the temperature of the refrigerant entering (returning to) the evaporator 104.

In at least one example, a system for controlling pumped two-phase refrigerant temperature can include a pump configured to pump a refrigerant through an evaporator in thermal communication with a heat load, a condenser in fluid communication with the pump and the evaporator, a controller configured to control a temperature of the refrigerant entering the evaporator to minimize single-phase cooling in the evaporator, or any combination thereof. In at least one example, heat from the heat load can heat refrigerant in the evaporator, thereby causing at least some of the refrigerant to change from a liquid phase to a vapor phase. In at least one example, the condenser can be configured to cool the refrigerant fluidically downstream from the evaporator, thereby causing at least some of the refrigerant to change from the vapor phase to the liquid phase before returning to the pump. In at least one example, a system for controlling pumped two-phase refrigerant temperature can further include a compressor configured to inject the refrigerant in the vapor phase fluidically between the pump and the evaporator.

In at least one example, a system for controlling pumped two-phase refrigerant temperature can further include a separator configured to separate refrigerant extracted fluidically between the evaporator and the condenser into a portion of the refrigerant in the vapor phase and a portion of the refrigerant in the liquid phase. In at least one example, the separator can be configured to inject the portion of the refrigerant in the liquid phase fluidically between the pump and the condenser.

In at least one example, the controller can be configured to control a speed of the compressor according to the temperature of the refrigerant entering the evaporator. In at least one example, the controller can be configured to monitor the temperature and pressure of the refrigerant entering the evaporator. In at least one example, the controller can be configured to control a valve downstream of the compressor according to the temperature of the refrigerant entering the evaporator.

In at least one example, a system for controlling pumped two-phase refrigerant temperature can include a plurality of two-phase cold plates, a pump configured to pump a refrigerant through the plurality of two-phase cold plates, a condenser in fluid communication with the pump and the plurality of two-phase cold plates, a separator in fluid communication with the condenser and the plurality of two-phase cold plates, a compressor configured to inject the portion of the refrigerant in the vapor phase fluidically between the pump and the plurality of two-phase cold plates, a controller configured to control the speed of the compressor to minimize single-phase cooling in the plurality of two-phase cold plates, or any combination thereof. In at least one example, any or all of the two-phase cold plates can be in thermal communication with a heat load. In at least one example, any or all of the two-phase cold plates can be plumbed in parallel fluid communication with one another. In at least one example, any or all of the two-phase cold plates can be plumbed in series fluid communication with one another. In at least one example, heat from the heat load(s) can heat refrigerant within any or all of the plurality of two-phase cold plates, thereby causing at least some of the refrigerant to change from a liquid phase to a vapor phase. In at least one example, the controller can be configured to monitor the temperature and/or pressure of the refrigerant entering one or more of a plurality of two-phase cold plates.

In at least one example, the condenser can be configured to cool the refrigerant fluidically downstream from the plurality of two-phase cold plates, thereby causing the refrigerant to change from the vapor phase to the liquid phase before returning to the pump. In at least one example, the separator can be configured to extract some of the refrigerant fluidically between the condenser and the plurality of two-phase cold plates. In at least one example, the separator can be configured to separate the extracted refrigerant into a portion of the refrigerant in the vapor phase and a portion of the refrigerant in the liquid phase. In at least one example, the separator can be configured to inject the portion of the refrigerant in the liquid phase fluidically between the pump and the condenser.

In at least one example, a method of controlling a temperature of a refrigerant can include pumping, such as with a pump, the refrigerant through an evaporator, thereby heating the refrigerant and causing at least some of the refrigerant to change from a liquid phase to a vapor phase, cooling the refrigerant in a condenser fluidically downstream from the evaporator, thereby causing at least some of the refrigerant to change from the vapor phase to the liquid phase before returning to the pump, extracting a portion of the refrigerant in the vapor phase fluidically between the evaporator and the condenser, injecting the extracted portion of the refrigerant, in the vapor phase, fluidically between the pump and the evaporator, thereby increasing the temperature of the refrigerant entering the evaporator, or any combination thereof. In at least one example, the evaporator can be in thermal communication with a heat load.

In at least one example, injecting the extracted portion of the refrigerant in the vapor phase can include compressing, such as with a compressor, the extracted portion of the refrigerant in the vapor phase. In at least one example, a method of controlling a temperature of a refrigerant can further include separating the extracted portion of the refrigerant extracted between the evaporator and the condenser into the portion of the refrigerant in the vapor phase and a portion of the refrigerant in the liquid phase.

In at least one example, a method of controlling a temperature of a refrigerant can further include injecting the portion of the refrigerant in the liquid phase fluidically between the pump and the condenser. In at least one example, a method of controlling a temperature of a refrigerant can further include controlling a speed of the compressor according to the temperature of the refrigerant entering the evaporator. In at least one example, a method of controlling a temperature of a refrigerant can further include monitoring the temperature and pressure of the refrigerant entering the evaporator. In at least one example, a method of controlling a temperature of a refrigerant can further include controlling a valve fluidically downstream of the compressor according to the temperature of the refrigerant entering the evaporator.

In at least one example, a method of controlling a temperature of a refrigerant can include ensuring that the extracted portion of the refrigerant extracted between the evaporator and the condenser is in the vapor phase. In at least one example, a method of controlling a temperature of a refrigerant can include ensuring that the extracted portion of the refrigerant extracted between the evaporator and the condenser is not in the liquid phase. In at least one example, a method of controlling a temperature of a refrigerant can include minimizing single-phase cooling in the evaporator by controlling the temperature of the refrigerant entering the evaporator.

Other and further examples utilizing one or more aspects of the disclosure can be devised without departing from the Applicants' disclosure. For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

Further examples are set out in the clauses below:
1.A method of controlling a temperature of a refrigerant, the method comprising:
   pumping, with a pump, the refrigerant through an evaporator in thermal communication with a heat load, thereby heating the refrigerant and causing at least some of the refrigerant to change from a liquid phase to a vapor phase;
   cooling the refrigerant in a condenser fluidically downstream from the evaporator, thereby causing at least some of the refrigerant to change from the vapor phase to the liquid phase before returning to the pump; extracting a portion of the refrigerant in the vapor phase fluidically between the evaporator and the condenser; and
   injecting the extracted portion of the refrigerant, in the vapor phase, fluidically between the pump and the evaporator, thereby increasing the temperature of the refrigerant entering the evaporator.
2.The method of clause 1, wherein injecting the extracted portion of the refrigerant in the vapor phase comprises compressing, with a compressor, the extracted portion of the refrigerant in the vapor phase.
3.The method of clause 2, further comprising separating the extracted portion of the refrigerant extracted between the evaporator and the condenser into the portion of the refrigerant in the vapor phase and a portion of the refrigerant in the liquid phase.
4.The method of clause 3, further comprising injecting the portion of the refrigerant in the liquid phase fluidically between the pump and the condenser.
5.The method of clause 2 or 3, further comprising controlling a speed of the compressor according to the temperature of the refrigerant entering the evaporator.
6.The method of clause 5, further comprising monitoring the temperature and a pressure of the refrigerant entering the evaporator.
7.The method of clause 2, further comprising controlling a valve fluidically downstream of the compressor according to the temperature of the refrigerant entering the evaporator.
8.The method of any one of the preceding clauses, further comprising ensuring that the extracted portion of the refrigerant extracted between the evaporator and the condenser is in the vapor phase.
9.The method of any one of the preceding clauses, further comprising ensuring that the extracted portion of the refrigerant extracted between the evaporator and the condenser is not in the liquid phase.
10.The method of any one of the preceding clauses, further comprising minimizing single-phase cooling in the evaporator by controlling the temperature of the refrigerant entering the evaporator.
11.A system, comprising:
   a pump configured to pump a refrigerant through an evaporator in thermal communication with a heat load, thereby heating the refrigerant and causing at least some of the refrigerant to change from a liquid phase to a vapor phase; a condenser in fluid communication with the pump and the evaporator, the condenser being configured to cool the refrigerant fluidically downstream from the evaporator, thereby causing at least some of the refrigerant to change from the vapor phase to the liquid phase before returning to the pump; and a controller configured to control a temperature of the refrigerant entering the evaporator to minimize single-phase cooling in the evaporator.
12.The system of clause 11, further comprising a compressor configured to inject the refrigerant in the vapor phase fluidically between the pump and the evaporator.
13.The system of clause 12, further comprising a separator configured to separate refrigerant extracted fluidically between the evaporator and the condenser into a portion of the refrigerant in the vapor phase and a portion of the refrigerant in the liquid phase.
14.The system of clause 13, wherein the separator is further configured to inject the portion of the refrigerant in the liquid phase fluidically between the pump and the condenser.
15.The system of any one of clauses 12-14, wherein the controller is further configured to control a speed of the compressor according to the temperature of the refrigerant entering the evaporator.
16.The system of clause 15, wherein the controller is further configured to monitor the temperature and a pressure of the refrigerant entering the evaporator.
17.The system of any one of clauses 12-16, wherein the controller is further configured to control a valve downstream of the compressor according to the temperature of the refrigerant entering the evaporator.
18.A system, comprising: a plurality of two-phase cold plates, each in thermal communication with a heat load, the plurality of two-phase cold plates being plumbed in parallel and/or series fluid communication with one another;
   a pump configured to pump a refrigerant through the plurality of two-phase cold plates, thereby heating the refrigerant and causing at least some of the refrigerant to change from a liquid phase to a vapor phase;
   a condenser in fluid communication with the pump and the plurality of two-phase cold plates, the condenser being configured to cool the refrigerant fluidically downstream from the plurality of two-phase cold plates, thereby causing the refrigerant to change from the vapor phase to the liquid phase before returning to the pump;
   a separator in fluid communication with the condenser and the plurality of two-phase cold plates, the separator being configured to extract some of the refrigerant fluidically between the condenser and the plurality of two-phase cold plates, and the separator being further configured to separate the extracted refrigerant into a portion of the refrigerant in the vapor phase and a portion of the refrigerant in the liquid phase;
   a compressor configured to inject the portion of the refrigerant in the vapor phase fluidically between the pump and the plurality of two-phase cold plates; and
   a controller configured to control the speed of the compressor to minimize single-phase cooling in the plurality of two-phase cold plates.
19.The system of clause 18, wherein the separator is further configured to inject the portion of the refrigerant in the liquid phase fluidically between the pump and the condenser.
20.The system of clause 18 or 19, wherein the controller is further configured to monitor the temperature and a pressure of the refrigerant entering the plurality of two-phase cold plates.

The inventions have been described in the context of preferred and other examples and not every example of the inventions has been described. Obvious modifications and alterations to the described examples are available to those of ordinary skill in the art having the benefits of the present disclosure. The disclosed and undisclosed examples are not intended to limit or restrict the scope or applicability of the inventions conceived of by the Applicants, but rather, in conformity with the patent laws, Applicants intend to fully protect all such modifications and improvements that come within the scope or range of equivalents of the following claims.

## Claims

1. A method of controlling a temperature of a refrigerant, the method comprising:
pumping, with a pump, the refrigerant through an evaporator in thermal communication with a heat load, thereby heating the refrigerant and causing at least some of the refrigerant to change from a liquid phase to a vapor phase;
cooling the refrigerant in a condenser fluidically downstream from the evaporator, thereby causing at least some of the refrigerant to change from the vapor phase to the liquid phase before returning to the pump;
extracting a portion of the refrigerant in the vapor phase fluidically between the evaporator and the condenser; and
injecting the extracted portion of the refrigerant, in the vapor phase, fluidically between the pump and the evaporator, thereby increasing the temperature of the refrigerant entering the evaporator.

2. The method of claim 1, wherein injecting the extracted portion of the refrigerant in the vapor phase comprises compressing, with a compressor, the extracted portion of the refrigerant in the vapor phase.

3. The method of claim 2, further comprising separating the extracted portion of the refrigerant extracted between the evaporator and the condenser into the portion of the refrigerant in the vapor phase and a portion of the refrigerant in the liquid phase.

4. The method of claim 3, further comprising injecting the portion of the refrigerant in the liquid phase fluidically between the pump and the condenser.

5. The method of any one of claims 2-4, further comprising controlling a speed of the compressor according to the temperature of the refrigerant entering the evaporator; and optionally
further comprising monitoring the temperature and a pressure of the refrigerant entering the evaporator.

6. The method of any one of claims 2-5, further comprising controlling a valve fluidically downstream of the compressor according to the temperature of the refrigerant entering the evaporator.

7. The method of any one of the preceding claims, further comprising ensuring that the extracted portion of the refrigerant extracted between the evaporator and the condenser is in the vapor phase; or optionally
further comprising ensuring that the extracted portion of the refrigerant extracted between the evaporator and the condenser is not in the liquid phase; or optionally
further comprising minimizing single-phase cooling in the evaporator by controlling the temperature of the refrigerant entering the evaporator.

8. A system, comprising:
a pump configured to pump a refrigerant through an evaporator in thermal communication with a heat load, thereby heating the refrigerant and causing at least some of the refrigerant to change from a liquid phase to a vapor phase;
a condenser in fluid communication with the pump and the evaporator, the condenser being configured to cool the refrigerant fluidically downstream from the evaporator, thereby causing at least some of the refrigerant to change from the vapor phase to the liquid phase before returning to the pump; and
a controller configured to control a temperature of the refrigerant entering the evaporator to minimize single-phase cooling in the evaporator.

9. The system of claim 8, further comprising a compressor configured to inject the refrigerant in the vapor phase fluidically between the pump and the evaporator.

10. The system of claim 9, further comprising a separator configured to separate refrigerant extracted fluidically between the evaporator and the condenser into a portion of the refrigerant in the vapor phase and a portion of the refrigerant in the liquid phase.

11. The system of claim 10, wherein the separator is further configured to inject the portion of the refrigerant in the liquid phase fluidically between the pump and the condenser.

12. The system of any one of claims 9-11, wherein the controller is further configured to control a speed of the compressor according to the temperature of the refrigerant entering the evaporator; and optionally
wherein the controller is further configured to monitor the temperature and a pressure of the refrigerant entering the evaporator.

13. The system of any one of claims 9-12, wherein the controller is further configured to control a valve downstream of the compressor according to the temperature of the refrigerant entering the evaporator.

14. A system, comprising:
a plurality of two-phase cold plates, each in thermal communication with a heat load, the plurality of two-phase cold plates being plumbed in parallel and/or series fluid communication with one another;
a pump configured to pump a refrigerant through the plurality of two-phase cold plates, thereby heating the refrigerant and causing at least some of the refrigerant to change from a liquid phase to a vapor phase;
a condenser in fluid communication with the pump and the plurality of two-phase cold plates, the condenser being configured to cool the refrigerant fluidically downstream from the plurality of two-phase cold plates, thereby causing the refrigerant to change from the vapor phase to the liquid phase before returning to the pump;
a separator in fluid communication with the condenser and the plurality of two-phase cold plates, the separator being configured to extract some of the refrigerant fluidically between the condenser and the plurality of two-phase cold plates, and the separator being further configured to separate the extracted refrigerant into a portion of the refrigerant in the vapor phase and a portion of the refrigerant in the liquid phase;
a compressor configured to inject the portion of the refrigerant in the vapor phase fluidically between the pump and the plurality of two-phase cold plates; and
a controller configured to control the speed of the compressor to minimize single-phase cooling in the plurality of two-phase cold plates.

15. The system of claim 14, wherein the separator is further configured to inject the portion of the refrigerant in the liquid phase fluidically between the pump and the condenser; or optionally
wherein the controller is further configured to monitor the temperature and a pressure of the refrigerant entering the plurality of two-phase cold plates.
